# EUROPÄISCHE PATENTSCHRIFT

(11) **EP 0 785 644 B1**
(45) Veröffentlichungstag und Bekanntmachung des Hinweises auf die Patenterteilung: **12.05.2004**
(21) Anmeldenummer: 97100448.6
(22) Anmeldetag: 14.01.1997
(51) Int. Cl.: H04L 1/00, H03M 13/27, H04L 1/22

(54) **Verfahren zur Datenübertragung zwischen zwei Stationen**
Method for data transmission between two stations
Procédé de transmission de données entre deux stations

(30) Priorität: 19.01.1996 CH 14696
(43) Veröffentlichungstag der Anmeldung: 23.07.1997
(73) Patentinhaber: Siemens Schweiz AG, 8047 Zürich (CH)
(72) Erfinder: Windisch, Arthur, 8184 Bachenbülach (CH); Zünd, Urs, 8307 Effretikon (CH)
(74) Vertreter: Berg, Peter, Dipl.-Ing.

(56) Entgegenhaltungen:
- EP-A- 0 075 852
- EP-A- 0 146 639
- EP-A- 0 596 736
- DE-A- 2 757 164
- US-A- 5 136 588
- US-A- 5 173 905
- US-A- 5 442 647
- IBM TECHNICAL DISCLOSURE BULLETIN, Bd. 38, Nr. 10, Oktober 1995, NEW YORK, US, Seiten 297-298, XP000540500 ANONYMOUS: "Error Protection for Memory Addressing"

## Beschreibung

Die vorliegende Erfindung betrifft ein Verfahren nach dem Oberbegriff des Patentanspruchs 1.

Im Zusammenhang mit der Steuerung des öffentlichen und privaten Verkehrs gewinnt die Kommunikation zwischen Fahrzeugen und Kommunikationseinheiten, die entlang den befahrenen Verkehrswegen fest installiert sind, vermehrt an Bedeutung. Z.B. werden einem Fahrzeug Maximal- oder Leitwerte für die Geschwindigkeit oder der Status von Signalanlagen gemeldet. Aus F. Gertler, H.-J. Stolzenberg, Das Zugbeeinflussungssystem ZUB 123, SIGNAL + DRAHT, 86 (1994), ist die Verwendung einer Gleiskoppelspule bekannt, in der mehrere adressierbare Streckentelegramme abgelegt sind. Bei einer Zugpassage kann ein einzelnes Telegramm abgerufen und an den vorbeifahrenden Zug übertragen werden. Aus Gründen der Sicherheit sind die zur Aufnahme der Telegramme vorgesehenen Speicherbausteine in jeder Gleiskoppelspule zweifach redundant vorgesehen. Damit diese Kommunikationssysteme ihre Arbeit dauerhaft erfüllen können und vereinzelt nicht selbst Gefährdungen hervorrufen, wird für diese Systeme ein hoher Sicherheitsstandard gefordert, der durch die Anwendung entsprechender Normen (z.B. PrEn50126, PrEn50127, PrEn50128, DIN 19250, Mü8004, etc.) erzielt und nachgewiesen werden kann. Der Aufwand zur Adressierung und fehlerfreien Übertragung eines einzelnen Telegramms ist daher beträchtlich. Zur Adressierung eines Telegramms muss die Adresse bei bekannten Systemen zudem in einem Zwischenspeicher abgelegt werden. Falls die im Zwischenspeicher abgelegte Information z.B. aufgrund einer defekten Datenleitung nicht korrekt aufdatiert wird oder der Speicherbaustein einen Defekt erleidet, besteht die Gefahr, dass anstelle der neuen die alte, nicht mehr gültige Signalisierungsinformation zum vorbeifahrenden Fahrzeug übertragen wird. Z.B. könnte dann anstelle des Signalbegriffs "HALT" der Signalbegriff "FAHRT" zum Fahrzeug übertragen werden. Kritisch ist die Übertragung unkorrekter Daten insbesondere dann, wenn der Übertragungsfehler empfangsseitig nicht offenbart wird und fehlerhaft übertragene Instruktionen ausgeführt werden.

In EP 0 596 736 A1 (Hewlett-Packard) ist ein Verfahren beschreiben, bei dem eine zu übermittelnde Datensequenz in Blöcke aufgeteilt wird. Dabei werden aufeinanderfolgende Blöcke über je einen eigenen Kanal übertragen. Um Störeinflüsse auf den Kanälen und damit das Entstehen von korrumpierten parallel übertragenen Datenblöcken zu reduzieren, ist die Übertragung der Blöcke in wenigstens einem Kanal gegenüber den anderen Kanälen zeitverzögert. Dabei sind die übertragenen Blöcke vor dem zusammenfügen zwischen zu speichern.

Der vorliegenden Erfindung liegt daher die Aufgabe zugrunde, ein Verfahren sowie ein System anzugeben, durch die Daten insbesondere zwischen erdgebundenen sowie mobilen Kommunikationseinheiten mit einer hohen Transferrate übertragen werden können, wobei auftretende Fehler jeweils offenbart werden.

Diese Aufgabe wird durch die im Patentanspruch 1 angegebenen Massnahmen gelöst. Vorteilhafte Ausgestaltungen der Erfindung sind in weiteren Ansprüchen angegeben.

Das erfindungsgemässe Verfahren erlaubt die Übertragung von relativ grossen Datenmengen mit reduzierter Fehlerwahrscheinlichkeit. Das erfindungsgemässe Kommunikationssystem ist kostengünstig realisierbar und kann mit einem vergleichsweise geringen Aufwand installiert werden.

Um die geforderte Sicherheit zu gewährleisten, müssen Speicherbausteine oder Übertragungsleitungen nicht mehr redundant vorgesehen werden. Falls ein Speicherbaustein einen Defekt erleidet, ist gewährleistet, dass der auftretende Fehler offenbart wird, so dass Korrekturmassnahmen ergriffen und gefährliche Situationen vermieden werden können.

Die Erfindung wird nachfolgend anhand einer Zeichnung beispielsweise näher erläutert. Dabei zeigt:
- Fig. 1: eine erfindungsgemässe Übertragungsvorrichtung bzw. Kommunikationssystem,
- Fig. 2: eine erfindungsgemässe Vorrichtung für die Übertragung von Daten von einer erdgebundenen Kommunikationseinheit zu einem Fahrzeug,
- Fig. 3: ein Fahrzeug bei der Fahrt über eine erdgebundene Kommunikationseinheit,
- Fig. 4: eine erweiterte erfindungsgemässe Übertragungsvorrichtung mit zwei erdgebundenen Kommunikationseinheiten.

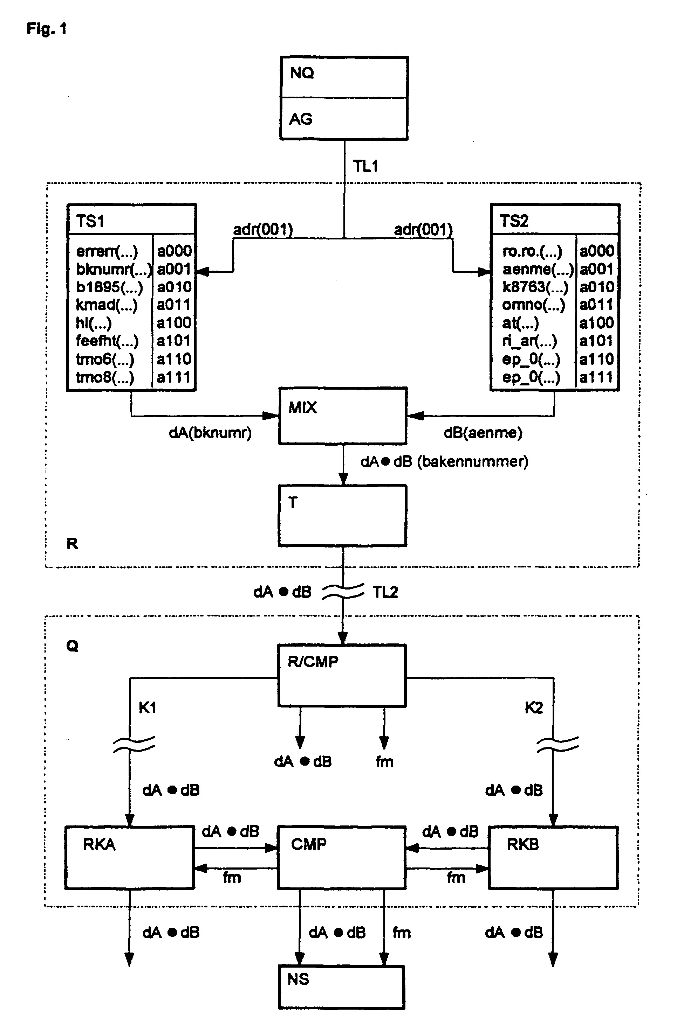

In Fig. 1 ist eine Übertragungsvorrichtung bzw. Kommunikationssystem gezeigt, bei der Informationen von einer Nachrichtenquelle NQ über eine erste Übertragungsleitung TL1 zu einer ersten Kommunikationseinheit R und von dort über eine zweite Übertragungsleitung TL2 bzw. einen logischen oder physikalischen Datenkanal sowie eine zweite Kommunikationseinheit Q zu einer Nachrichtensenke NS übertragen werden. Dazu werden von der Nachrichtenquelle NQ in der ersten Kommunikationseinheit R gespeicherte Telegramme entsprechend den zu übertragenen Daten adressiert, ausgelesen und an die zweite Kommunikationseinheit Q übertragen. Die den zu übertragenden Daten entsprechende Adressinformation adr (z.B. Adressnummer 001) wird in der Nachrichtenquelle NQ mittels eines darin integrierten Adressgenerators AG festgelegt. In der ersten Kommunikationseinheit R sind zwei Speichereinheiten TS1, TS2 vorgesehen, in denen unter gleichen Adressen zueinander korrespondierende Teile der wahlweise zu übertragenden Telegramme abgelegt sind. Die aus den beiden Speichereinheiten TS1, TS2 ausgelesenen Datenfragmente dA und dB werden in einer Mischstufe MIX zu einem vollständigen Telegramm dA·dB zusammengefügt und über eine Sendestufe T zur zweiten Kommunikationseinheit Q übertragen.

Die Aufteilung bzw. Fragmentierung der in den Speichereinheiten TS1, TS2 abzulegenden Telegramme erfolgt, ebenso wie das Zusammenfügen der Datenfragmente dA, dB in der Mischstufe MIX nach einer festgelegten Vorschrift. Z. B. wird festgelegt, dass die Datenbits der Telegramme alternierend, einzeln oder in Gruppen von wenigstens zwei Bits, der ersten und der zweiten Speichereinheit TS1, TS2 zugeordnet werden, so dass alle Datenfragmente dA und dB eines Telegramms mit der Abgabe einer einzigen Adressinformation ausgelesen und zusammengefügt werden können. Die Vorschrift, nach der zu übertragende Daten, insbesondere Telegramme und Schlüsselworte, aufgeteilt und in den Speichereinheiten TS1, TS2 abgelegt werden, kann beliebig gewählt werden. Vorzugsweise weisen die den Speichereinheiten TS1, TS2 zugeordneten Datenfragmente dA, dB jedoch den gleichen Datenumfang auf. Besonders vorteilhaft bei dem erfindungsgemässen Verfahren ist, dass die Auftrennung der Daten oder der Telegramme unabhängig bzw. ohne Berücksichtigung der verwendeten Datenstruktur erfolgen kann. Auf eine Rückübertragung der Daten für Kontrollzwecke kann zudem verzichtet werden.

Aus Fig. 1 ist ersichtlich, dass die zu übertragenden Telegramme z.B. buchstabenweise aufgetrennt und alternierend in Einheiten von einem Buchstaben den Speichereinheiten TS1, TS2 zugeordnet sind. An der Adresse 001 ist in den Speichereinheiten TS1, TS2 das Telegramm mit der Nachricht "BAKENNUMMER" abgelegt. Die Buchstaben sind gemäss obengenannter Fragmentierungsvorschrift aufgeteilt und entsprechend in den Speichereinheiten TS1, TS2 abgelegt. Tabelle 1 zeigt die Aufteilung des Telegramms, das den Begriff BAKENNUMMER enthält. Tabelle 2 zeigt die Zuordnung der vorschriftsgemäss gebildeten Datenfragmente an die Adresse 001 der Speichereinheiten TS1, TS2.

**Tabelle 1**

| TS1 | TS2 | TS1 | TS2 | TS1 | TS2 | TS1 | TS2 | TS1 | TS2 | TS1 |
|---|---|---|---|---|---|---|---|---|---|---|
| B | A | K | E | N | N | U | M | M | E | R |

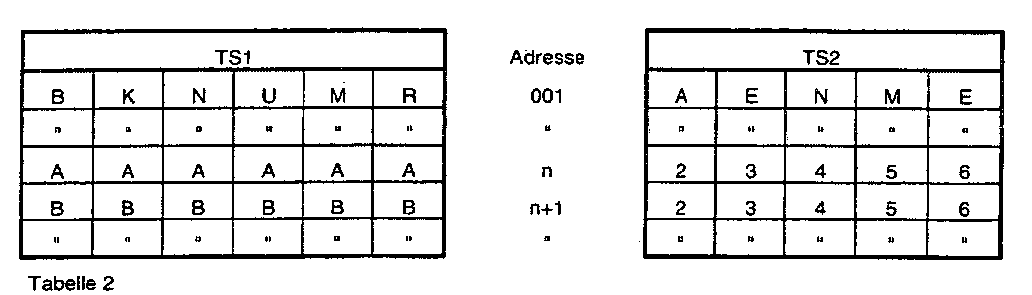

Beim Auslesen, nach Erhalt der Adressinformation 001, werden die Datenfragmente dA, dB aus den Speichereinheiten TS1, TS2 ausgelesen und in der Mischstufe MIX vorschriftsgemäss zusammengefügt und anschliessend übertragen. Empfangsseitig kann nun festgestellt werden, ob ein gültiges Telegramm dA·dB übertragen wurde. D.h., ob der Inhalt des Telegramm dA•dB Element einer Gruppe von zulässigen Datenwörtern ist, die in der Kommunikationseinheit Q abgelegt sind.

Mängel bei der Fehleroffenbarung können hierbei auftreten, falls in einer der Speichereinheiten TS1, TS2 zwei identische Datensätze abgelegt sind. Gemäss Tabelle 2 sind in der Speichereinheit TS2 an den Adressen n sowie n+1 dieselben Daten (23456) abgelegt. Wird z.B. durch einen Defekt der Dekodierlogik die Speichereinheit TS1 blockiert, so werden anstelle der an der Adresse n liegenden Daten (AAAAAA) noch immer die an der Adresse n+1 liegenden Daten (BBBBBB) abgegeben. Die in der Speichereinheit TS1 an der Adresse n+1 liegenden Daten (BBBBBB) sowie die in der Speichereinheit TS2 an der Adresse n liegenden Daten (23456) können daher zu einer Nachricht zusammengefügt werden, ohne dass empfangsseitig ein Fehler festgestellt wird. Zur Verhinderung derartiger Fehleroffenbarungsmängel wird bei jeder Adresse zusätzlich zu den Nutzdaten ein Prüfwort aufgeteilt in den Speichereinheiten TS1, TS2 abgelegt. Damit eine Aufteilung des Prüfworts auf beide Speichereinheiten TS1, TS2 korrekt erfolgt, muss die Grösse der Datenfragmente kleiner gewählt werden, als die Grösse des Prüfworts.

Die Kontrolle der aus den Speichern TS1 und TS2 ausgelesenen Datenfragmente dA und dB kann ferner bereits sendeseitig erfolgen. Z.B. wird durch die Mischstufe MIX nach dem Zusammenfügen der Datenfragmente dA und dB die Korrektheit der in den wiedererstellten Daten enthaltenen Prüfinformation festgestellt. Das Zusammenmischen der Datenfragmente dA und dB kann zudem auch erst empfangsseitig erfolgen. Die Datenfragmente dA und dB werden dazu getrennt über zwei logische oder zwei physikalische Kanäle von der ersten zur zweiten Kommunikationseinheit R bzw. Q übertragen und erst in der zweiten Kommunikationseinheit Q zusammengemischt und geprüft.

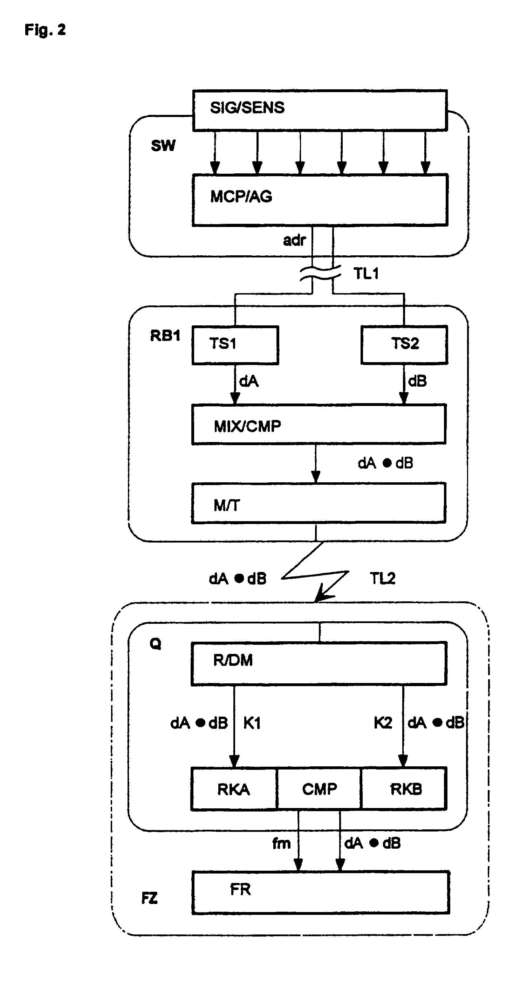

In Fig. 2 ist eine erfindungsgemässe Übertragungsvorrichtung dargestellt, die es erlaubt, Informationen von einem Stellwerk SW an eine in einem Fahrzeug FZ vorgesehene mobile Kommunikationseinheit Q zu übermitteln, von der sie z.B. an einen Leitrechner FR abgegeben werden. Dem Stellwerk SW werden Signale z.B. von einer Leitstelle, von Fahrzeugen oder von Sensoren über eine Schnittstellenbaugruppe SIG/SENS zugeführt. Die von der Schnittstellenbaugruppe SIG/SENS abgegebenen Daten werden in einer logischen Schaltung oder in einem Prozessor MCP/AG in eine zu den empfangenen Signalen korrespondierende Adressinformation bzw. Adresse adr umgewandelt, durch die ein Telegramm adressierbar ist, das fragmentiert in Speichereinheiten TS1, TS2 abgelegt ist, die in einer ersten Kommunikationseinheit RB1 vorgesehen sind. Vom Stellwerk SW wird die Adressinformation adr vorzugsweise getrennt in zwei logischen oder physikalischen Kanälen über eine Übertragungsleitung TL1 zur ersten Kommunikationseinheit RB1 übertragen. Die getrennte Übertragung der Adressinformation adr zur ersten Kommunikationseinheit RB1 erlaubt die zusätzliche Offenbarung von Fehlern die entlang der Übertragungsleitung TL1 auftreten. Die aus den Speichereinheiten TS1, TS2 ausgelesenen Datenfragmente dA und dB werden in der ersten Kommunikationseinheit RB1 zu einer Mischstufe MIX/CMP übertragen, in der die Datenfragmente dA und dB korrekt zu einem Telegramm dA•dB zusammengefügt und vorzugsweise noch geprüft werden. Das Telegramm dA•dB bzw. die darin enthaltenen Daten werden anschliessend in einer Sendestation M/T auf ein hochfrequentes Trägersignal moduliert, das von der ersten Kommunikationseinheit RB1 über einen Luftspalt TL2 zur beispielsweise mobilen zweiten Kommunikationseinheit Q bzw. zu einer darin vorgesehenen Empfangseinheit R/DM übertragen und dort demoduliert wird. Die demodulierten Daten bzw. das Telegramm dA•dB werden weiter zu einem Komparator CMP übertragen, dort geprüft und zusammen mit allfälligen Fehlermeldungen fm an den Leitrechner FR eines Fahrzeugs FZ abgegeben. Von der Empfangseinheit R/DM kann das Telegramm dA·dB ein- oder zweikanalig über weitere Empfangseinheiten RKA, RKB zum Komparator CMP übertragen werden. Durch die zweikanalige Übertragung können gegebenenfalls auf einem der beiden Übertragungswege auftretende Fehler festgestellt werden.

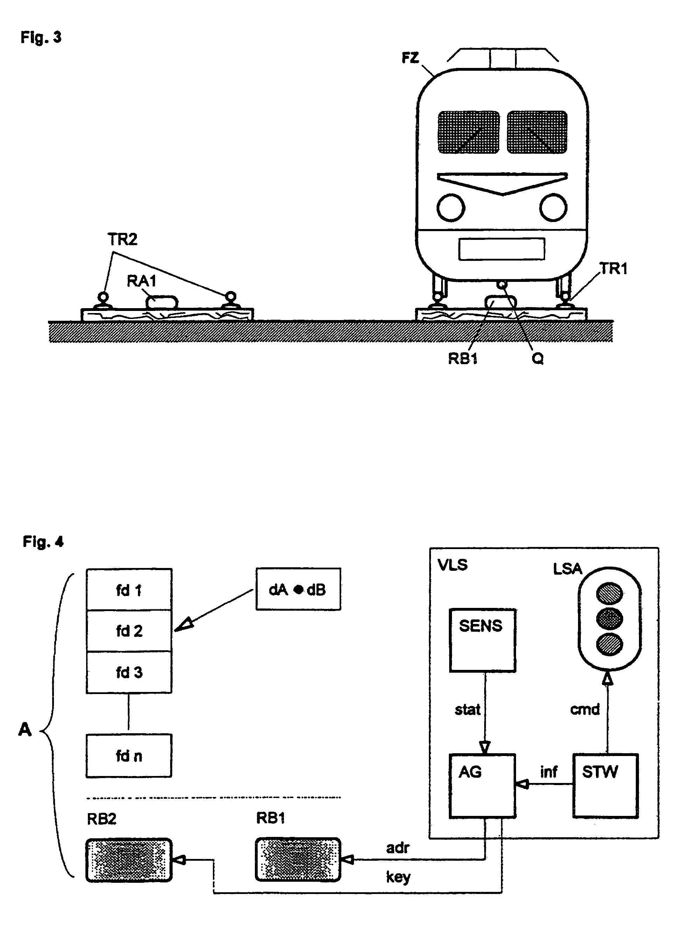

Das erfindungsgemässe Verfahren und die Vorrichtungen sind vorzugsweise in der Verkehrstechnik einsetzbar. Fig. 3 zeigt zwei nebeneinander geführte Schienenpaare TR1, TR2 auf denen mit mobilen Kommunikationseinheiten Q versehene Fahrzeuge FZ geführt sind. An verkehrstechnisch wichtigen Stellen, z.B. vor Kreuzungen, sind Streckenposten mit wenigstens einer erdgebundenen Kommunikationseinheit RA1 bzw. RB1 vorgesehen, die zur Übertragung von Daten an die mobilen Kommunikationseinheiten Q vorgesehen sind. Informationen können z.B. nur von einer erdgebundenen Kommunikationseinheit R zu einer mobilen Kommunikationseinheit Q übertragen werden. Oft kommt jedoch auch eine bidirektionale Übertragung von (Nutz-) Daten zwischen den Kommunikationseinheiten Q, R zur Anwendung. Durch die mobilen Kommunikationseinheiten Q werden die Daten von den erdgebundenen Kommunikationseinheiten (Baken, Balisen) z.B. auch abgefragt.

Die Übertragung von Daten von der erdgebundenen ersten Kommunikationseinheit RB1 zur mobilen zweiten Kommunikationseinheit Q erfolgt z.B. wie unter Fig. 2 beschrieben. Um die zur zweiten Kommunikationseinheit Q übertragene Datenmenge weiter zu Erhöhen werden mehrere Datenblöcke fd1, ..., fd n, die mögliche Zustände an einem betreffenden Streckenposten beschreiben, von der ersten oder einer weiteren erdgebundenen Kommunikationseinheit RB2 zur mobilen Kommunikationseinheit Q übertragen. Von diesen Datenblöcken fd1, ..., fd n, wird derjenige durch das übertragene Telegramm dA·dB adressiert, der die momentan gültigen Zustandsdaten enthalt. Entsprechend den Daten und Zuständen, die an einem Streckenpunkt möglicherweise auftreten können und/oder permanent vorliegen, werden in den weiteren Datenblöcken entsprechende feste Zustandsdaten vorgesehen. Die im Datenblock x enthaltenen Zustandsdaten beschreiben z.B. den Zustand des Streckenpunktes, bei dem eine zugehörige Signalisierung auf "Halt" gesetzt ist. Die im Datenblock x+1 enthaltenen Zustandsdaten beschreiben z.B. den Zustand des Streckenpunktes, bei dem die Signalisierung auf "Fahrt" gesetzt ist. Durch diese vorzugsweise Ausgestaltung des erfindungsgemässen Verfahrens erfolgt eine doppelte Adressierung. In einem ersten Schritt wird ein in der erdgebundenen Kommunikationseinheit R abgelegtes Telegramm adressiert, durch das nach der Übertragung in einem zweiten Schritt einer von mehreren zur mobilen Kommunikationseinheit Q übertragenen Datenblöcke fd1, ..., fd n adressiert wird.

In Fig. 4 sind einem Streckenpunkt A zwei erdgebundene Kommunikationseinheiten RB1, RB2 zugeordnet. Die zur Abgabe von Schlüsseldaten vorgesehene Kommunikationseinheit RB1 ist über eine Datenleitung mit dem Verkehrsleitsystem VLS verbunden, das einen Adress- oder Schlüsselgenerator AG aufweist, dem Meldungen und Statusinformationen inf, stat von einem mit einer Lichtsignalanlage LSA verbundenen Stellwerk STW, einem Sensor SENS und/oder weiteren verkehrstechnischen Anlagen zugeführt werden. In Abhängigkeit der anliegenden Informationen inf, stat werden im Adressgenerator AG Adressdaten erzeugt, die zur ersten erdgebundenen Kommunikationseinheit RB1 übertragen werden. Dort wird erfindungsgemäss ein Telegramm dA•dB gebildet, das zur mobilen Kommunikationseinheit Q übertragen wird und das zur Adressierung oder Identifizierung eines von mehreren Datenblöcken fd1, fd2, ..., fd n vorgesehen ist, die von der zweiten erdgebundenen Kommunikationseinheit RB2 zur mobilen Kommunikationseinheit Q übertragen wurden.

Zur Unterscheidung der Datenblöcke fd1, ..., fd n, die der mobilen Kommunikationseinheit Q vom zugehörigen Streckenpunkt bzw. von der zugehörigen erdgebundenen Kommunikationseinheit RB1 bzw. RB2 zugesandt werden, von Datenblöcken, die von fremden Kommunikationseinheiten (siehe Fig. 3, Kommunikationseinheit RA1) stammen, werden vorzugsweise alle Datenblöcke fd1, ..., fd n mit einem für jeden Datenblock individuell gewählten Schlüssel kodiert (z.B. XOR-verknüpft). Anstelle einer Adressinformation, die den mit den gültigen Zustandsdaten versehenen Datenblock fd unmittelbar bezeichnet, wird derjenige Schlüssel übertragen, der es erlaubt, in der mobilen Kommunikationseinheit Q die gültigen Zustandsdaten korrekt zu dekodieren (z.B. durch die zweite XOR-Vernüpfung mit dem zugehörigen Schlüssel). In jedem mit Zustandsdaten gefüllten Datenblock fd1, ..., fd n wird zudem eine Checksumme vorgesehen, die es erlaubt, festzustellen, ob ein mit Zustandsdaten gefüllter Datenblock fd korrekt dekodiert wurde. Anstelle der Übermittlung einer Adressinformation wird der dem mit den gültigen Zustandsdaten versehenen Datenblock fd entsprechende Schlüssel in das Telegramm dA•dB eingefügt. Nach der Übertragung werden alle Datenblöcke fd in der zweiten Kommunikationseinheit Q mit dem im Telegramm dA•dB enthaltenen Schlüssel dekodiert bzw. (EX-OR) verknüpft. Dabei wird nur der mit den gültigen Zustandsdaten versehene Datenblock fd korrekt dekodiert. Alle weiteren Datenblöcke fd, die mit diesem für sie falschen Schlüssel verknüpft werden, enthalten daher keine sinnvolle Informationen mehr. Durch die Prüfung einer vorgesehenen Checksumme kann daher der mit den gültigen Zustandsdaten versehene Datenblock fd eindeutig identifiziert werden. Falls der übertragene Schlüssel zu keinem der Zustandsdaten versehenen Datenblöcke fd passt, so wird in der mobilen Kommunikationseinheit Q ein Fehler registriert.

Ein in der mobilen Kommunikationseinheit Q detektierter Fehler wird dem Zugführer gemeldet, der die notwendigen Massnahmen ergreift und/oder es werden Befehle an die Steuerung des Antriebssystems abgegeben, durch die entsprechend vorgesehene Massnahmen ergriffen werden. Vorzugsweise wird der aufgetretene Fehler dem Zugführer mitgeteilt, wobei gleichzeitig eine automatische Temporeduktion eingeleitet wird.

Die aus den Speichereinheiten TS1, TS2 ausgelesenen Telegramme dA•dB können nebst den Adress- bzw. Schlüsseldaten noch weitere Informationen enthalten. Z.B. können innerhalb eines Streckenpunktes Sensoren vorgesehen sein, die den Zustand der erdgebundenen Kommunikationseinheiten R überwachen und dementsprechende Statusinformationen abgeben.

Die in den erdgebundenen Kommunikationseinheiten RB benötigte Versorgungsleistung kann über die Datenleitung vom Verkehrsleitsystem VLS oder über den Luftspalt von der mobilen Kommunikationseinheit Q erfolgen. Die Datenblöcke fd1, fd2, ..., fd n können in der zweiten erdgebundenen Kommunikationseinheit RB2 in programmierbaren Speichereinheiten abgelegt sein. Ferner können kodierte Oberflächenwellenfilter vorgesehen sein, die durch einen Sendepuls abgefragt werden. Gemäss der WO 94/11754 wird von einer mobilen Kommunikationseinheit Q ein Abfragepuls an ein mit Interdigitalwandlern und Reflektoren versehenes Oberflächenbauteil OFW übertragen, das in einer erdgebundenen Kommunikationseinheit R angeordnet ist. Entsprechend der Anordnung und/oder Programmierbarkeit der Reflektoren wird eine feste oder zumindest teilweise veränderliche Sequenz von Antwortimpulsen zur mobilen Kommunikationseinheit Q reflektiert.

### Bezugszeichenliste

- A: Streckenpunkt
- adr: Adressinformation, Adresse
- CMP: Komparator
- dA: Datenfragment
- dB: Datenfragment
- fd1, .. , fdn: Datenblöcke
- FZ: Fahrzeug
- inf: Meldungen
- LSA: Lichtsignalanlage
- MCP: Prozessor
- MIX: Mischstufe
- M/T: Sendestation
- NQ: Nachrichtenquelle
- NS: Nachrichtensenke
- OFW: Oberfächenbauteil
- Q: Kommunikationseinheit, mobile zweite Kommunikationseinheit
- R: Kommunikationseinheit
- RB: erdgebundene Kommunikationseinheit
- RB1, RB2: Kommunikationseinheit, erste, zweite
- RKA, RKB: Empfangseinheiten
- SIG/SENS: Schnittstelienbaugruppe
- stat: Statusinformationen
- SW: Stellwerk
- TR1: Schienenpaar
- TR2: Schienenpaar
- VLS: Verkehrsteitsystem
- T: Sendestufe
- TL1: Übertragungsleitung
- TL2: Luftspalt
- TS1: Speichereinheit
- TS2: Speichereinheit
- x: Datenblock

## Patentansprüche

1. Verfahren zur fehleroffenbarenden Übertragung von Daten von einer Nachrichtenquelle (NQ) zu einer Nachrichtensenke (NS) mit einer ersten Kommunikationseinheit (R, RB1), in der Telegramme abgespeichert sind, die durch die Nachrichtenquelle (NQ) entsprechend den zu übertragenen Daten adressiert, ausgelesen und an eine zweite mit der Nachrichtensenke (NS) verbundene Kommunikationseinheit (Q) übertragen werden,
**gekennzeichnet durch** folgende Verfahrensschritte,
A die Telegramme werden nach einer festgelegten Vorschrift in wenigstens zwei je in Speichereinheiten (TS1; TS2) abzulegende Datenfragmente (dA, dB) aufgeteilt und an Adressen (adr) der Speichereinheit abgelegt;
B bei jeder Adresse wird zusätzlich zum Datenfragment ein Prüfwort abgelegt;
C zueinander korrespondierende Datenfragmente (dA, dB) einschliesslich der zugehörigen Prüfworte werden von der Nachrichtenquelle (NQ) adressiert, aus den Speichereinheiten (TS1, TS2) ausgelesen und über einen Übertragungskanal (TL2) zur zweiten Kommunikationseinheit (Q) übertragen;
D in der ersten oder in der zweiten Kommunikationseinheit (R, RB1, Q) ist eine Mischstufe (MIX) vorgesehen, in der die Datenfragmente (dA, dB) zu einem vollständigen Telegramm (dA•dB) zusammengefügt werden und der Mischstufe (MIX) ist ein Komparator (CMP) nachgeschaltet ist, **durch** den festgestellt wird, ob das übertragene Prüfwort gültig ist.

2. Verfahren nach Anspruch 1,
**dadurch gekennzeichnet dass**,
die in den Speichereinheiten (TS1; TS2) abgelegten Datenfragmente (dA, dB) kleiner als die entsprechenden zu übertragende Prüfworte gewählt werden.

3. Verfahren nach Anspruch 1 oder 2,
**dadurch gekennzeichnet dass**,
die erste Kommunikationseinheit (R, RB1) erdgebunden an einem Streckenpunkt (A) eines Verkehrsweges und die zweite Kommunikationseinheit (Q) auf einem entlang dem Verkehrsweg geführten Fahrzeug (FZ) angeordnet ist, dass von der ersten und/oder einer weiteren erdgebundenen Kommunikationseinheit (RB1; RB2) Datenblöcke (fd1, .. , fd n) an die Kommunikationseinheit (Q), abgegeben werden, von denen wenigstens einer mittels des übertragenen Telegramms (dA•dB) in der Kommunikationseinheit (Q) als gültig identifiziert wird.

4. Verfahren nach Anspruch 3,
**dadurch gekennzeichnet, dass**
das Telegramm (dA•dB) zur Adressierung eines der Datenblöcke (fd1, ..., fd n) vorgesehen ist oder, dass die Datenblöcke (fd1, ..., fd n) mit einem für jeden Datenblock (fd1, ..., fd n) individuellen Schlüssel kodiert sind und dass im Telegramm (dA•dB) derjenige Schlüssel eingefügt wird, durch den der gültige Datenblock (fd1; ...; fd n) empfangsseitig dekodiert werden kann.

5. Verfahren nach Anspruch 4,
**dadurch gekennzeichnet, dass**
alle zur Kommunikationseinheit (Q) übertragenen Datenblöcke (fd1, ..., fd n) mit Checksummen versehen sind und dass der gültige Datenblock (fd1; ...; fd n) identifiziert wird, indem alle übertragenen Datenblöcke (fd1, ..., fd n) mit dem im Telegramm (dA•dB) enthaltenen Schlüssel dekodiert werden und dass derjenige Datenblock (fd1; ...; fd n) weiterverarbeitet wird, dessen Checksumme korrekt dekodiert wurde.

6. Verfahren nach einem der Ansprüche 1 bis 5,
**dadurch gekennzeichnet, dass**
die Adressen (adr) von der Nachrichtenquelle (NQ) getrennt zu den in der ersten Kommunikationseinheit (RB1) vorgesehenen Speichereinheiten (TS1; TS2) übertragen werden.

## Claims

1. Method for error-disclosing transmission of data from a message source (NQ) to a message sink (NS) with a first communications unit (R, RB1), in which telegrams are stored which are addressed, read out and transmitted to a second communications unit (Q) connected to the message sink (NS) by the message source (NQ) in accordance with the data to be transmitted,
**characterized by** the following steps,
A the telegrams are divided up in accordance with a defined specification into at least two data fragments (dA, dB) each to be stored in memory units (TS1; TS2) and stored at addresses (adr) of the memory unit;
B at each address a checkword is stored in addition to the data fragment;
C data fragments corresponding to each other (dA, dB), including the associated checkwords, are addressed by the message source (NQ) read out by the memory units (TS1, TS2) and transmitted via a transmission channel (TL2) to the second communications unit (Q) ;
D a mixing stage (MIX) is provided in the first or in the second communications unit (R, RB1, Q), in which the data fragments (dA, dB) are combined ito a complete telegram (dA•dB) and a comparator (CMP) is connected downstream of the mixing stage (MIX) which is used to establish whether the checkword transmitted is valid.

2. Method in accordance with Claim 1,
**characterized in that**,
the data fragments (dA, dB) stored in the memory units (TS1; TS2) are selected to be smaller than the corresponding checkwords to be transmitted.

3. Method in accordance with Claim 1 or 2,
**characterized in that**,
the first communications unit (R, RB1) is grounded to a point (A) of a transport route and the second communications unit (Q) is located on a vehicle (FZ) driven along the transport route, that data blocks (fd1, .. , fd n) are issued from the first and/or a further grounded communications unit (RB1; RB2) to the communications unit (Q), of which at least one is identified as valid in the communications unit (Q) by means of the transmitted telegram (dA•dB).

4. Method in accordance with Claim 3,
**characterized in that**
the telegram (dA•dB) for addressing one of the data blocks (fd1, ..., fd n) is provided or that the data blocks (fd1, ..., fd n) are encoded with an individual key for each data block (fd1, ..., fd n) and that the key inserted into the data block (dA•dB) is the one by which the valid data block can be decoded (fd1; ...; fd n) on the receiver side.

5. Method in accordance with Claim 4,
**characterized in that**
all data blocks (fd1, .... fd n) transmitted to the communications unit (Q) are provided with checksums and that the valid data block (fd1; ...; fd n) will be identified when all transmitted data blocks (fd1, ... , fd n) aer decoded with the key contained in the telegram (dA•dB)and that the data block (fd1; ...; fd n) that will be further processed is the one for which the checksum was correctly decoded.

6. Method in accordance with one of Claims 1 to 5,
**characterized in that**
the addresses (adr) are transmitted separately by the message source (NQ) to the memory units (TS1; TS2) provided in the first communications unit (RB1).

## Revendications

1. Procédé pour la transmission de données, révélant les erreurs éventuelles, d'une source de messages (NQ) à un puits de messages (NS), ayant une première unité de communication (R, RB1) dans laquelle sont mémorisés des télégrammes qui sont adressés par la source de messages (NQ) en fonction des données à transmettre, qui sont lus et qui sont transmis à une deuxième unité de communication (Q) reliée au puits de messages (NS),
**caractérisé par** les étapes opératoires suivantes :
A les télégrammes sont divisés selon une règle fixée en au moins deux fragments de données (dA, dB) à enregistrer respectivement dans des unités de mémoire (TS1 ; TS2) et sont enregistrés à des adresses (adr) de l'unité de mémoire ;
B à chaque adresse, un mot de contrôle est enregistré en plus du fragment de données ;
C des fragments de données se correspondant (dA, dB) y compris les mots de contrôle associés sont adressés par la source de message (NQ), sont lus dans les unités de mémoire (TS1, TS2) et sont transmis via un canal de transmission (TL2) à la deuxième unité de communication (Q) ;
D dans la première ou dans la deuxième unité de communication (R, RB1, Q), il est prévu un étage mélangeur (MIX) dans lequel les fragments de données (dA, dB) sont réunis en un télégramme complet (dA • dB) et un comparateur (CMP) est branché du côté aval de l'étage mélangeur (MIX) pour vérifier si le mot de contrôle transmis est valide.

2. Procédé selon la revendication 1,
**caractérisé par le fait que** les fragments de données (dA, dB) enregistrés dans les unités de mémoire (TS1 ; TS2) sont choisis inférieurs aux mots de contrôle à transmettre correspondants.

3. Procédé selon la revendication 1 ou 2,
**caractérisé par le fait que** la première unité de communication (R, RB1) est agencée au sol en un point de trajet (A) d'une voie de circulation et la deuxième unité de communication (Q) est agencée sur un véhicule (FZ) guidé le long de la voie de circulation, que des blocs de données (fd1, ..., fd n) sont délivrés par la première et/ou une autre unité de communication au sol (RB1 ; RB2) à l'unité de communication (Q), au moins l'un de ces blocs de données étant identifié comme valide dans l'unité de communication (Q) au moyen du télégramme transmis (dA • dB).

4. Procédé selon la revendication 3,
**caractérisé par le fait que** le télégramme (dA • dB) est prévu pour l'adressage d'un des blocs de données (fd1, ..., fd n) ou que les blocs de données (fd1, ..., fd n) sont codés avec une clé individuelle pour chaque bloc de données (fd1, ..., fd n) et que la clé par laquelle peut être décodé côté réception le bloc de données valide (fd1 ; ... ; fd n) est insérée dans le télégramme (dA • dB).

5. Procédé selon la revendication 4,
**caractérisé par le fait que** tous les blocs de données (fd1, ..., fd n) transmis à l'unité de communication (Q) sont munis de sommes de contrôle et que le bloc de données valide (fd1 ; ... ; fd n) est identifié en décodant tous les blocs de données transmis (fd1, ..., fd n) avec la clé contenue dans le télégramme (dA • dB) et que le bloc de données (fd1 ; ... ; fd n) dont la somme de contrôle a été décodée correctement est traité ensuite.

6. Procédé selon l'une des revendications 1 à 5,
**caractérisé par le fait que** les adresses (adr) sont transmises par la source de messages (NQ) séparément aux unités de mémoire (TS1 ; TS2) prévues dans la première unité de communication (RB1).
